# EUROPEAN PATENT APPLICATION

(11) **EP 4 398 222 A1**
(43) Date of publication of application: **10.07.2024**
(21) Application number: 22864367.2
(22) Date of filing: 24.08.2022
(51) Int. Cl.: G09F 9/00, B32B 7/023, G02B 5/30

(54) **MULTI-LAYER STRUCTURE**

(30) Priority: 31.08.2021 JP 2021141383
(71) Applicant: Nitto Denko Corporation, Ibaraki-shi, Osaka 567-8680 (JP)
(72) Inventor: INAGAKI, Junichi, Ibaraki-shi, Osaka 567-8680 (JP); SATO, Keisuke, Ibaraki-shi, Osaka 567-8680 (JP); WATANABE, Ryo, Ibaraki-shi, Osaka 567-8680 (JP)
(74) Representative: Hoffmann Eitle
(86) International application number: PCT/JP2022/031857
(87) International publication number: WO 2023/032783

(57) **Abstract**

A multilayer structure includes a polarizing plate; a glass layer laminated on one side of the polarizing plate via an adhesive layer; and an optical display laminated on another side of the polarizing plate via a bonding layer, wherein the glass layer has a thickness of 10 um or more and 300 um or less, and a thickness x of the bonding layer and an elastic modulus y of the bonding layer at 85 °C satisfy y ≥ (299/60)x - 296/3.

## Description

### Technical Field

The present invention relates to a multilayer structure.

### Background Art

A multilayer structure in which two or more layers are laminated is known. An example is a multilayer structure in which an agglutinant layer, a resin layer, an adhesive layer, and a glass layer are laminated in this order. In this multilayer structure, the thickness of the glass layer is preferably 30 um to 300 um. Further, in the multilayer structure, the thickness and elastic modulus of the agglutinant layer are defined in a wide range.

### Citation List

### Patent Document

Patent document 1: WO 2019/087938

### Summary of Invention

### Technical Problem

However, a thin glass layer having the above-mentioned plate thickness is very brittle and minute cracks tend to be formed in the glass layer. Therefore, it is necessary to have a configuration that can prevent the extension of cracks even if minute cracks are formed in the glass layer.

In view of the above, an object of the present invention is to provide a multilayer structure capable of preventing the extension of cracks even when cracks are formed in a glass layer.

### Solution to Problem

A multilayer structure includes a polarizing plate; a glass layer laminated on one side of the polarizing plate via an adhesive layer; and an optical display laminated on another side of the polarizing plate via a bonding layer, wherein the glass layer has a thickness of 10 um or more and 300 um or less, and a thickness x of the bonding layer and an elastic modulus y of the bonding layer at 85 °C satisfy y ≥ (299/60)x - 296/3.

### [Advantageous Effects of Invention]

According to the disclosed technique, it is possible to provide a multilayer structure capable of preventing the extension of cracks even when cracks are formed in a glass layer.

### Brief Description of Drawings

[FIG. 1] FIG. 1 is a cross-sectional view illustrating an example of a multilayer structure according to the present embodiment.
[FIG. 2] FIG. 2 is a cross-sectional view illustrating an example of a polarizing plate according to the present embodiment.
[FIG. 3] FIG. 3 is a diagram illustrating the relationship between the thickness and the elastic modulus of a bonding layer and the crack extension rate of the glass layer.

### Description of Embodiments

Hereinafter, an embodiment for carrying out the present invention will be described with reference to the drawings. In each drawing, the same elements are denoted by the same reference numerals, and duplicate descriptions may be omitted.

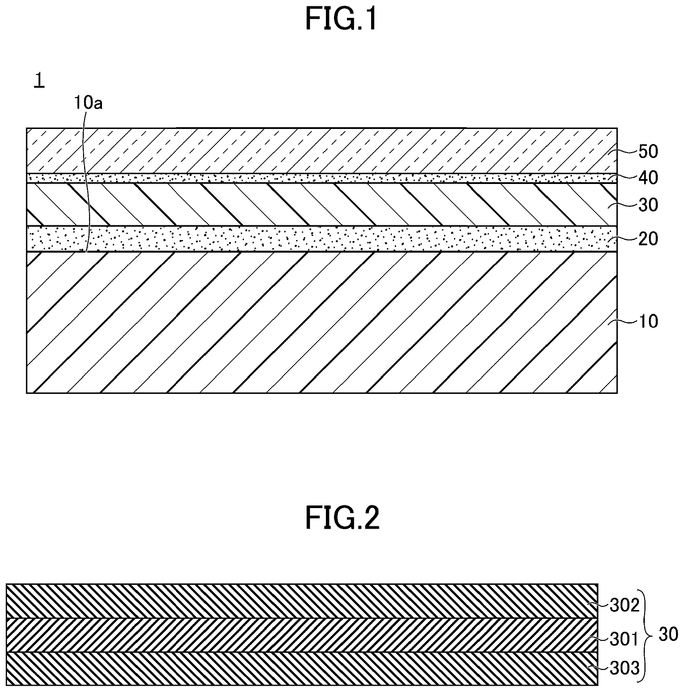

FIG. 1 is a cross-sectional view illustrating an example of a multilayer structure according to the present embodiment. As illustrated in FIG. 1, a multilayer structure 1 includes an optical display 10, a bonding layer 20, a polarizing plate 30, an adhesive layer 40, and a glass layer 50. The glass layer 50 is laminated on one side of the polarizing plate 30 via the adhesive layer 40, and the optical display 10 is laminated on the other side of the polarizing plate 30 via the bonding layer 20.

However, the multilayer structure 1 may be composed of the bonding layer 20, the polarizing plate 30, the adhesive layer 40, and the glass layer 50. In this case, a person who has obtained a laminate of the bonding layer 20, the polarizing plate 30, the adhesive layer 40, and the glass layer 50 can use the laminate for a display device or the like by attaching the bonding layer 20 side of the laminate to an upper surface 10a of the optical display 10.

The planar shape of the multilayer structure 1 (the shape viewed from the direction normal to the upper surface 10a of the optical display 10) is, for example, rectangular. However, the planar shape of the multilayer structure 1 is not limited to being rectangular, and may be circular, elliptical, a composite of these, or any other suitable shape.

The materials, etc., of each part of the multilayer structure 1 will now be described.

### [Optical display]

The optical display 10 is not particularly limited to a display capable of displaying predetermined information. The optical display 10 includes, for example, a display having one of the following elements: liquid crystal, organic electroluminescence (organic EL), inorganic electroluminescence (inorganic EL), a light emitting diode (LED), and quantum dots. Note that the LED herein includes a micro-LED.

The thickness of the optical display 10 is, for example, 0.4 mm to 0.7 mm. The elastic modulus of the optical display 10 is, for example, 50 GPa to 100 GPa.

For example, if the optical display is a liquid crystal display, the optical display 10 has a liquid crystal layer sandwiched between two transparent substrates. The liquid crystal layer includes, for example, liquid crystal molecules homogeneously aligned in the absence of an electric field. For example, an IPS type liquid crystal layer is preferably used as the liquid crystal layer, but a liquid crystal layer of a TN type, a STN type, a π type, a VA type or the like may be used. The thickness of the liquid crystal layer is, for example, approximately 1.5 um to 4 um. The two transparent substrates have, for example, the same thickness. The two transparent substrates are, for example, made of glass.

### [Bonding layer]

The bonding layer 20 is arranged between the optical display 10 and the polarizing plate 30. Any gluing agent or adhesive agent can be used as the bonding layer 20. A suitable thickness and a suitable elastic modulus of the bonding layer 20 will be described later.

In the present specification, the gluing agent is a layer which has adhesiveness at ambient temperature and that adheres to an adherend by a light pressure. Therefore, the gluing agent retains a practical agglutinant force even when the adherend attached to the gluing agent is peeled off. On the other hand, an adhesive agent is a layer that can bind substances by intervening between the substances. Therefore, when the adherend attached to the adhesive agent is peeled off, the adhesive agent has no practical adhesive force.

When a gluing agent is used for the bonding layer 20, for example, a gluing agent based on a polymer such as an acrylic polymer, a silicone polymer, a polyester, a polyurethane, a polyamide, a polyether, a fluorine polymer, a rubber polymer or the like is used. When a gluing agent is used for the bonding layer 20, an acrylic gluing agent is preferably used. This is because the acrylic gluing agent has excellent optical transparency, exhibits moderate wettability, cohesiveness, and agglutinant properties, and can be excellent in weather resistance, heat resistance, etc. In particular, an acrylic gluing agent made of an acrylic polymer having 4 to 12 carbon atoms is preferable.

When an adhesive agent is used for the bonding layer 20, for example, a polyester adhesive, a polyurethane adhesive, a polyvinyl alcohol adhesive, and an epoxy adhesive are used. When the adhesive agent is a thermosetting adhesive, the peeling resistance can be exerted by heating and curing (solidification). When the adhesive agent is a light-curing adhesive such as an ultraviolet curing adhesive, the peeling resistance can be exerted by curing by irradiation with light such as ultraviolet rays. Further, when the adhesive agent is a moisture-curing adhesive, the adhesive can be cured by reacting with moisture in air, etc., and, therefore, the adhesive can be cured and the peeling resistance can be exerted even by abandoning the adhesive.

### [Polarizer]

The polarizing plate 30 is laminated on the upper surface 10a of the optical display 10 via a bonding layer 20. As illustrated in FIG. 2, the polarizing plate 30 includes, for example, a polarizer 301, a first protective film 302, and a second protective film 303. The first protective film 302 is arranged on the adhesive layer 40 side of the polarizer 301, and the second protective film 303 is arranged on the bonding layer 20 side of the polarizer 301. The polarizing plate 30 may have only the first protective film 302 or the second protective film 303.

The thickness of the polarizing plate 30 is preferably 5 um to 300 um, more preferably 10 um to 250 um, even more preferably 25 um to 200 um, and particularly preferably 25 um to 100 µm.

The elastic modulus of the polarizing plate 30 is preferably 1 GPa or more, more preferably 1 GPa to 10 GPa, even more preferably 2 GPa to 7 GPa, and particularly preferably 2 GPa to 5 GPa.

The shape of the polarizing plate 30 is not particularly limited, and suitable shapes can be adopted depending on the purpose, but an example is a rectangular shape having long and short sides. When the polarizing plate 30 has a rectangular shape, it is preferable that the absorption axis direction of the polarizer 301 of the polarizing plate 30 is substantially parallel to the long or short side of the polarizing plate 30. In the present specification, the term "substantially parallel" includes not only the case of being strictly parallel but also the case where the angle formed by both lines is ±10° (preferably ±5°).

### [Polarizer]

The thickness of the polarizer 301 is not particularly limited, and an appropriate thickness can be adopted according to the purpose. The thickness of the polarizer 301 is typically approximately 1 um to 80 um. A thin polarizer may be used as the polarizer 301, in which case the thickness of the polarizer 301 is preferably 20 um or less, more preferably 15 um or less, even more preferably 10 um or less, and particularly preferably 6 um or less.

The polarizer 301 preferably exhibits absorption dichroism at any wavelength from 380 nm to 780 nm. The monolithic transmittance of the polarizer is preferably 40.0% or more, more preferably 41.0% or more, even more preferably 42.0% or more, and particularly preferably 43.0% or more. The degree of polarization of the polarizer 301 is preferably 99.8% or more, more preferably 99.9% or more, and even more preferably 99.95% or more.

The polarizer 301 is preferably an iodine-based polarizer. The iodine-based polarizer can be composed of a polyvinyl alcohol-based resin (hereinafter referred to as "PVA-based resin") film containing iodine. As the PVA-based resin for forming the PVA-based resin film, there is no particular limitation, and an appropriate resin can be adopted depending on the purpose, but examples include polyvinyl alcohol and ethylene-vinyl alcohol copolymer.

### [First and second protective films]

The first protective film 302 and the second protective film 303 are not particularly limited, and suitable resin films can be adopted according to the purpose. The materials forming the first protective film 302 and the second protective film 303 include, for example, polyester-based resins such as polyethylene terephthalate (PET), cellulose-based resins such as triacetylcellulose (TAC), cycloolefin-based resins such as norbornene-based resins, olefin-based resins such as polyethylene and polypropylene, and (meth) acrylic-based resins. Among these, cellulose-based resins and (meth) acrylic-based resins are preferable. The term "(meth) acrylic-based resins" refers to acrylic-based resins and/or methacrylic-based resins.

The thickness of the first protective film 302 and the second protective film 303 is preferably 4 um to 250 um, more preferably 5 um to 150 um, even more preferably 10 um to 100 um, and particularly preferably 10 um to 50 um.

The elastic modulus of the first protective film 302 and the second protective film 303 is 1 GPa or more, preferably 1 GPa to 10 GPa, more preferably 1.8 GPa to 7 GPa, and even more preferably 2 GPa to 5 GPa.

### [Adhesive layer]

The adhesive layer 40 is arranged between the polarizing plate 30 and the glass layer 50. The adhesive layer 40 is preferably formed of a material having a high visible light transmittance. The thickness of the adhesive layer 40 is, for example, 0.1 um or more and 25 um or less. As the adhesive layer 40, for example, a polyester-based adhesive, a polyurethane-based adhesive, a polyvinyl alcohol-based adhesive, and an epoxy-based adhesive are used.

### [Glass layer]

The glass layer 50 is laminated on the polarizing plate 30 via the adhesive layer 40. The glass layer 50 is not particularly limited and may be adopted as appropriate according to the purpose. The glass layer 50 may be, for example, soda-lime glass, boric acid glass, aluminosilicate glass, quartz glass, and the like according to the classification by composition. Further, the glass layer 50 may be non-alkali glass or low-alkali glass according to the classification by an alkali component. The content of the alkali metal component (for example, Na₂O, K₂O, Li₂O) of the above glass is preferably 15 wt.% or less, and more preferably 10 wt.% or less.

The thickness of the glass layer 50 is preferably 10 um or more in consideration of the surface hardness, airtightness, and corrosion resistance of glass. The glass layer 50 is preferably flexible like a film, and, therefore, the thickness of the glass layer 50 is preferably 300 um or less. The thickness of the glass layer 50 is more preferably 20 um or more and 200 um or less, particularly preferably 30 um or more and 150 um or less.

The optical transmittance of the glass layer 50 at a wavelength of 550 nm is preferably 85% or more. The refractive index of the glass layer 50 at a wavelength of 550 nm is preferably 1.4 to 1.65. The density of the glass layer 50 is preferably 2.3 g/cm³ to 3.0 g/cm³ and more preferably 2.3 g/cm³ to 2.7 g/cm³.

The method of molding the glass layer 50 is not particularly limited and a suitable method may be adopted according to the purpose. Typically, the glass layer 50 can be formed by melting a mixture containing a main raw material such as silica or alumina, an antifoaming agent such as mirabilite or antimony oxide, and a reducing agent such as carbon at a temperature of approximately 1400 °C to 1600 °C, molding this mixture into a thin plate, and cooling the plate. Examples of molding methods of the glass layer 50 include a slot-down draw method, a fusion method, a float method, and the like. The glass layer formed in the form of a plate by these methods may be chemically polished with a solvent such as hydrofluoric acid, if necessary, in order to thin the glass layer or improve smoothness.

A functional layer such as an antifouling layer, an antireflection layer, a conductive layer, a reflection layer, or a decoration layer may be provided on the upper surface of the glass layer 50 (the surface on which the adhesive layer 40 is not formed).

### [Method of manufacturing multilayer structure]

First, the polarizing plate 30 and the glass layer 50 are laminated via the adhesive layer 40. For example, a roll-to-roll process can be adopted for the lamination. That is, while conveying the polarizing plate 30 wound in a roll and the glass layer 50 wound in a roll in the same direction, the adhesive layer 40 is sandwiched between two rolls arranged facing each other and is pressed, so that the layers are laminated via the adhesive layer 40.

Next, the laminated body of the polarizing plate 30, the adhesive layer 40, and the glass layer 50 is cut by using a laser or the like, and is divided into separate pieces. The laminated body of the polarizing plate 30, the adhesive layer 40, and the glass layer 50 divided into separate pieces, is laminated on the upper surface 10a of the optical display 10 via the bonding layer 20, thereby completing the multilayer structure 1.

### [Preventing extension of cracks in glass layer]

In the manufacturing process of the multilayer structure 1, when the laminated body of the polarizing plate 30, the adhesive layer 40 and the glass layer 50 is divided into separate pieces, the glass layer 50 is cut under the condition such that cracks are not formed. However, if a minute crack was to be formed in the glass layer 50 in the cutting process, there is a risk that the crack in the glass layer 50 will extend when the multilayer structure 1 is placed in a high-temperature environment (for example, 85 °C) after being bonded to the optical display 10.

Here, consideration is given about the tensile force F in the plane direction (the left and right directions in FIG. 1) generated by thermal expansion in a layer when a temperature difference ΔT occurs in a layer. Assuming that σ expresses the stress, E expresses the elastic modulus, ε expresses the thermal strain, α expresses the linear expansion coefficient, A expresses the cross-sectional area, W expresses the width, and d expresses the thickness, σ=Eε=EαΔT and F=σA=σdW are satisfied, and F=EαdWΔT is obtained as a result.

**[Table 1]**

| | Elastic modulus E [Gpa] | Linear expansion coefficient α [ppm/°C] | Thickness d [mm] | Eαd |
|---|---|---|---|---|
| Optical display 10 | 70 | 4 | 0.4 to 0.7 | 112 to 196 |
| Film | 3 | 50 | 0.1 to 0.2 | 15 to 30 |

When comparing the optical display 10 with a general film, the values of E, α, and d are approximately as indicated in Table 1. The polarizing plate 30 has characteristics equivalent to a general film. In the multilayer structure 1, the values of W and ΔT of the optical display 10 and the polarizing plate 30 are the same, and, therefore, it can be seen that the tensile force F of the optical display 10 having a larger value of Eαd, is larger than the tensile force F of the polarizing plate 30. Thus, when the multilayer structure 1 is placed in a high-temperature environment (for example, 85 °C), the main cause of extension of a crack in the glass layer 50 is presumed to be the tensile force F generated in the optical display 10 by thermal expansion.

Therefore, the inventors considered that in order to prevent the extension of cracks in the glass layer 50, it is effective to make it difficult for the glass layer 50 to follow the thermal expansion of the optical display 10 by making the bonding layer 20 thin and highly elastic, and carried out an experiment.

A sample of the multilayer structure used in an experiment had a rectangular planar shape which was 150 mm long and 210 mm wide. Further, instead of the optical display 10, a glass plate with a thickness of 400 um was used, assuming the optical display 10. The thickness of the polarizing plate 30 was 85 um, the thickness of the adhesive layer 40 was 1.5 um, and the thickness of the glass layer 50 was 100 um. The elastic modulus of the glass plate assuming the optical display 10 was 70 GPa, the elastic modulus of the polarizing plate 30 was 3 GPa, the elastic modulus of the adhesive layer 40 was 7 GPa, and the elastic modulus of the glass layer 50 was 70 GPa.

Then, samples of a plurality of multilayer structures in which the bonding layer 20 has different values in thickness and elastic modulus were prepared, and a plurality of cracks with a length of approximately 15 mm in the planar view and penetrating in the thickness direction were formed in the glass layer 50 in advance. After the samples of the multilayer structures were stored in an environment of 85 °C for 15 minutes, the crack extension rate in the planar view was measured. The planar view is viewed from the direction normal to the upper surface of the glass layer 50.

Here, the crack extension rate is the number of extended cracks/the number of formed cracks. For example, if 100 cracks are formed and 19 cracks are extended, the crack extension rate is 19%. If the crack extension rate is 10% or less, it is considered that there is no problem in practical use when the multilayer structure 1 is used as a display device, etc., and therefore, the crack extension rate of 10% or less is acceptable.

The elastic modulus was measured by the nanoindentation method by using a nanoindenter (Triboindenter manufactured by Hysitron Inc.). A conical (spherical indenter: radius of curvature 10 um) was used as the indenter, and the elastic modulus was measured by the single indenter method at room temperature and at 85 °C under the measurement condition of the indentation depth of approximately 2 um.

**[Table 2]**

| Thickness of bonding layer [µm] | Elastic modulus of bonding layer [10⁴ Pa] | Crack extension rate [%] |
|---|---|---|
| 1 | 700,000 | 0 |
| 20 | 446 | 6 |
| 20 | 48 | 10 |
| 30 | 35 | 50 |
| 40 | 48 | 19 |
| 50 | 11.9 | 100 |
| 60 | 48 | 33 |

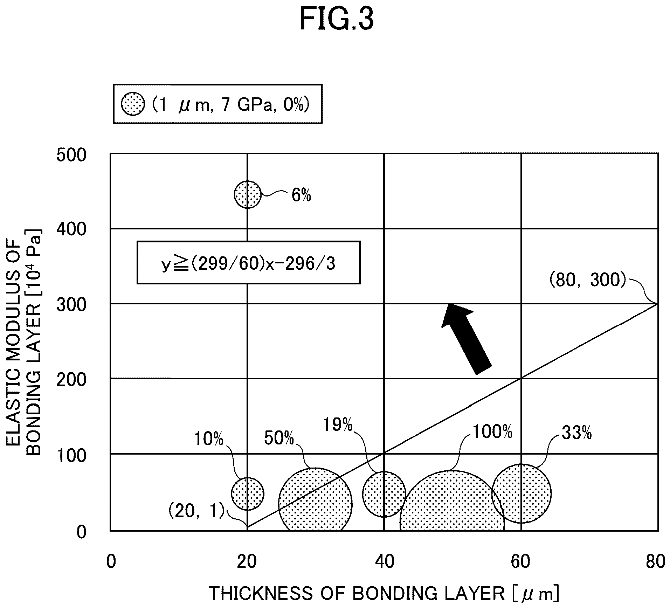

Table 2 and FIG. 3 indicate the measurement results of the crack extension rate. The elastic modulus in Table 2 and FIG. 3 is the elastic modulus at 85 °C measured by the nanoindentation method. In Table 2, the bonding layer 20 having a thickness of 1 um is formed by using an adhesive agent, and the bonding layers 20 having other thicknesses were formed by using a gluing agent. As a result, the elastic modulus of the bonding layer 20 having a thickness of 1 um is substantially higher than that of the bonding layers 20 having other thicknesses. FIG. 3 illustrates that the larger the diameter of the circle, the higher the crack extension rate. In FIG. 3, the elastic modulus of the bonding layer 20 having a thickness of 1 um is significantly higher than the elastic moduli of other thicknesses, and is therefore illustrated outside the framework of the graph as a matter of convenience.

From the results illustrated in Table 2 and FIG. 3, it can be said that if the crack extension rate is on the arrow side with respect to the inclined straight line in FIG. 3, the crack extension rate is 10% or less, in which case the multilayer structure can be used for practical use. That is, when the thickness of the bonding layer 20 is set to x [um] and the elastic modulus of the bonding layer 20 is set to y [10⁴ Pa], by satisfying y ≥ (299/60)x - 296/3, the extension of the crack in the glass layer 50 can be prevented.

The elastic modulus of the bonding layer 20 can be varied, for example, by adjusting the composition of the monomer (molecular weight, crosslinking density, glass transition temperature, etc.). When a gluing agent is used as the bonding layer 20, it is relatively easy to adjust the thickness in the range of 20 um or more and 50 um or less, and the elastic modulus in the range of 500×10⁴ Pa or less, and it is further easy to adjust the elastic modulus in the range of 60×10⁴ Pa or less. When an adhesive agent is used as the bonding layer 20, it is also possible to adjust the thickness in the range of 0.1 um or more and 5 um or less, and the elastic modulus in the range of 1 GPa or more.

As a result of repeated careful examination, the inventors have found that the extension of a crack can be prevented if a crack is formed in the glass layer 50 when the dimensional variation rate of the polarizing plate 30 is a predetermined percentage or less. To reduce the dimensional variation rate of the polarizing plate 30, for example, the polarizing plate 30 alone can be annealed under a predetermined condition.

Although the preferred embodiments, etc. have been described in detail above, the present invention is not limited to the above-described embodiments, etc., and various modifications and substitutions can be made to the above-described embodiments, etc., without departing from the scope described in the claims.

The present international application is based on and claims priority to Japanese Patent Application No. 2021-141383, filed on August 31, 2021, the contents of which are incorporated herein by reference in their entirety.

### Reference Signs List

1 multilayer structure
10 optical display
10a upper surface
20 bonding layer
30 polarizing plate
40 adhesive layer
50 glass layer
301 polarizer
302 first protective film
303 second protective film

## Claims

1. A multilayer structure comprising:
a polarizing plate;
a glass layer laminated on one side of the polarizing plate via an adhesive layer; and
an optical display laminated on another side of the polarizing plate via a bonding layer, wherein
the glass layer has a thickness of 10 um or more and 300 um or less, and
a thickness x of the bonding layer and an elastic modulus y of the bonding layer at 85 °C satisfy y ≥ (299/60)x - 296/3.

2. The multilayer structure according to claim 1, wherein
the bonding layer is formed of a gluing agent, and
the thickness of the bonding layer is 50 um or less.

3. The multilayer structure according to claim 2, wherein the elastic modulus of the bonding layer is 500×10⁴ Pa or less.

4. The multilayer structure according to claim 1, wherein
the bonding layer is formed of an adhesive agent, and
the thickness of the bonding layer is 5 um or less.

5. The multilayer structure according to claim 4, wherein
the bonding layer is formed of the adhesive agent, and
the elastic modulus of the bonding layer is 1 GPa or more.
